# EUROPEAN PATENT SPECIFICATION

(11) **EP 2 522 031 B1**
(45) Date of publication and mention of the grant of the patent: **20.08.2014**
(21) Application number: 11701871.3
(22) Date of filing: 05.01.2011
(51) Int. Cl.: H01L 31/0747, H01L 31/0224, H01L 27/142, H01L 31/0352, H01L 31/18

(54) **SOLAR PANEL MODULE AND METHOD FOR MANUFACTURING SUCH A SOLAR PANEL MODULE**
SONNENKOLLEKTORMODUL UND VERFAHREN ZUR HERSTELLUNG EINES SOLCHEN SONNENKOLLEKTORMODULS
MODULE DE PANNEAUX SOLAIRES ET PROCÉDÉ DE FABRICATION D'UN TEL MODULE DE PANNEAUX SOLAIRES

(30) Priority: 06.01.2010 NL 2004065
(43) Date of publication of application: 14.11.2012
(73) Proprietor: Stichting Energieonderzoek Centrum Nederland, 1755 LE Petten (NL)
(72) Inventor: Van Roosmalen, Johannes Adrianus Maria, NL-1755 LE Petten (NL); Bronsveld, Paula Catharina Petronella, NL-1755 LE Petten (NL)
(74) Representative: Nederlandsch Octrooibureau
(86) International application number: PCT/NL2011/050004
(87) International publication number: WO 2011/084053

(56) References cited:
- EP-A2- 1 995 792
- DE-A1- 19 943 720
- US-A- 4 200 472
- US-A- 4 283 589
- US-A1- 2008 121 266
- CHAPPEL T I: "THE V-GROOVE MULTIJUNCTION SOLAR CELL", IEEE TRANSACTIONS ON ELECTRON DEVICES, IEEE SERVICE CENTER, PISACATAWAY, NJ, US, vol. ED-26, no. 7, 1 July 1979 (1979-07-01), pages 1091-1097, XP002018004, ISSN: 0018-9383

## Description

The present invention relates to a solar panel module. Additionally, the present invention relates to a method for manufacturing such a solar panel module.

A solar panel module comprises a carrying frame and a plurality of solar cells which are supported by the carrying frame. Each solar cell is constructed to have at least one light receiving surface which is capable to capture radiation energy from a radiation source, e.g. the sun, and convert the radiation energy into electric energy. Typically, the carrying frame of the solar panel module comprises a mounting carrier and a transparent carrier. The solar cells are mounted or sandwiched between the mounting carrier and the transparent carrier in such a way that the light receiving surface of the solar cells is directed towards the transparent carrier.

The transparent carrier is typically a glass plate or a foil layer which covers the light receiving surfaces of the solar cells as a protective layer.

Each solar cell comprises at least an electrode of a first polarity and a counter electrode of a second, opposite, polarity to allow tapping the captured electric energy from the solar cell.

From the prior art it is known to arrange solar cells in an electrical series connection to form a high voltage solar cell arrangement which improves the efficiency of the module by preventing ohmic losses that would result from parallel connected solar cells. A single silicon solar cell typically generates a potential of about 0 to about 0.7 Volt.

One concept of series-connected solar cells is known from international application WO 0245143, which discloses a semiconductor wafer processing method to increase the usable planar surface area of the semiconductor wafer. The semiconductor wafer has a substantially planar surface and a thickness dimension at right angles to said substantially planar surface. The method includes the steps of selecting a strip thickness for division of the wafer into a plurality of strips, selecting a technique for cutting the wafer into the strips at an angle to the substantially planar surface, in which the combined strip thickness and width of wafer removed by the cutting is less than the thickness of the wafer, cutting the wafer into strips using the selected technique and separating the strips from each other.

After the cutting of the wafer into strips, the strips are still fixed in the processed wafer. In the fixed form the strips are exposed to a process to form bifacial solar cell strips on the cut surfaces of the individual strips. The solar cell strips comprise metallic contacts on selected areas of the strips. After separation the solar cell strips are arranged next to each other and electrically interconnected. Finally, the solar cell strips are arranged between glass sheets to form a solar panel module.

Due to the sequence of first separating the strips, next arranging them adjacent to each other, and subsequently interconnecting them, the method to form a solar panel from the prior art is complex.

It is also known that screen printing of contacts is a cumbersome process with typically low uptime and significant cell breakage. As such, screen printing adversely affects advanced manufacturing concepts that aim for improved throughput and yield.

Well known in the art are also the V-groove multijunction solar cells disclosed in US 42 00 472, DE 1994 3720, US 4283589 and "The V-groove multijunction solar cell", IEEE transactions on electron devices, IEEE service center, Pisacataway, US, vol. ED-26, n° 7. 1 july 1979, pages 1091-1097, by T.I Chappel et al. HIT solar cells are moreover disclosed in US 2008 121266 and EP 1995 792.

It is an object of the present invention to provide a high voltage solar cell which overcomes or removes one or more of the disadvantages of the prior art.

The present invention relates to a solar panel module comprising:
a transparent carrier, silicon semiconductor substrate portions, having a front surface and a rear surface, the front surface being arranged in use for capturing radiation energy;
the semiconductor substrate portions being arranged adjacent to each other on the transparent carrier and being separated from each other by a groove, each semiconductor substrate portion being attached with the front surface to the transparent carrier, each groove comprising a side wall of each of the semiconductor substrate portions adjacent to each other;
the semiconductor substrate portions being of a bulk conductivity type;
the front surface of each semiconductor substrate portion being provided with a doped layer of a first conductivity type;
each semiconductor substrate portion comprising a first electric contact for minority charge carriers in the semiconductor substrate portion and a second electric contact for majority charge carriers in the semiconductor substrate portion;
the first electric contact being arranged on at least the rear surface of the semiconductor substrate portion, wherein the first electric contact is a heterostructure of a first type, the heterojunction of the first type comprising an intrinsic semiconductor layer on the semiconductor substrate portion and a semiconductor layer of a second conductivity type on top of the intrinsic semiconductor layer, the second conductivity type being opposite to the first conductivity type.

Advantageously, the layout of the solar panel module allows the production of high efficiency low cost solar panel modules by minimizing the amount of metals used for interconnection, which is a significant cost advantage and by minimizing the ohmic and shadow losses that go together with metallization, which is a performance advantage. Further, the present invention may allow to produce solar panels without the use of silver for metallization which is a cost and sustainability advantage and without screenprinting as a inefficient, throughput limiting metallization technology. Moreover, the present invention may allow to produce crystalline silicon solar panel modules with high throughput on large areas (panel area versus wafer area). Also, the present invention may allow the use of thin crystalline silicon wafers because of limited handling and thermal budget limited high temperature processing, minimizing stress, which is a cost advantage. The use of back-contact heterojunctions for high efficiencies and excellent surface passivation is a further enabler of using thin wafers and low temperature manufacturing processes.

According to an embodiment, the present invention relates to the solar panel module as described above, wherein the layer of intrinsic semiconductor material comprises amorphous silicon.

According to an embodiment, the present invention relates to the solar panel module as described above, wherein the layer of semiconductor material of the second conductivity type comprises amorphous silicon containing one or more dopant species, resulting in the second conductivity type.

According to an embodiment, the present invention relates to the solar panel module as described above, wherein the intrinsic semiconductor layer covers the groove between adjacent semiconductor substrate portions.

According to an embodiment, the present invention relates to the solar panel module as described above, wherein the semiconductor material layer of the second conductivity type covers at least substantially the rear surface.

According to an embodiment, the present invention relates to the solar panel module as described above, wherein the semiconductor material layer of the second conductivity type covers the sidewall of the semiconductor substrate portion that does not comprise the second electric contact.

According to an embodiment which is not part of the present invention a solar panel module as described above is disclosed, wherein the front surface of the semiconductor substrate portions is provided with an anti-reflective coating and a passivation layer.

According to an embodiment which is not part of the present invention a solar panel module as described above is disclosed, wherein the first electric contact is a junction formed by a low-temperature junction formation process.

According to an embodiment, the present invention relates to the solar panel module as described above, wherein the second electric contact is a highly doped contact area of the first conductivity type, in one side wall of the semiconductor substrate portion.

According to an embodiment, the present invention relates to the solar panel module as described above, wherein the second electric contact is a highly doped contact area of the first conductivity type, on a portion of the rear surface of the semiconductor substrate portion adjacent to the first electric contact.

According to an embodiment, the present invention relates to the solar panel module as described above, wherein the second electric contact is a heterojunction of a second type, the heterojunction of the second type comprising an intrinsic semiconductor layer and a semiconductor layer of the first conductivity type, substantially on one side wall of the semiconductor substrate portion.

According to an embodiment, the present invention relates to the solar panel module as described above, wherein a conductive layer is arranged on the rear surface and side walls of each semiconductor substrate portion, and wherein on each semiconductor substrate portion the conductive layer comprises an interrupting element between the location of the first electric contact and the location of the second electric contact.

According to an embodiment, the present invention relates to the solar panel module as described above, wherein the interrupting element is either a slit in the conductive layer or an isolator step element in the conductive layer.

According to an embodiment, the present invention relates to the solar panel module as described above, wherein a passivation layer is arranged on the highly doped contact area, the passivation layer having an opening for exposure of at least a portion of the highly doped contact area for connection with the conductive layer.

According to an embodiment, the present invention relates to the solar panel module as described above, wherein the groove between adjacent semiconductor substrate portions is filled with an insulating material.

According to an embodiment which is not part of the present invention a solar panel module as described above is disclosed, wherein the insulating material is an encapsulating material for encapsulating the solar cell in a solar panel.

According to an embodiment, the present invention relates to the solar panel module as described above, wherein the groove between adjacent semiconductor substrate portions is bridged by a bridging element.

According to an embodiment, the present invention relates to the solar panel module as described above, wherein the groove is tapered in a direction from the transparent carrier towards the rear surface side of the semiconductor substrate portions.

According to an embodiment, the present invention relates to the solar panel module as described above, wherein the groove is either perpendicular to the rear surface or tapered in a direction from the rear surface side of the semiconductor substrate portions towards the transparent carrier.

According to an embodiment, the present invention relates to the solar panel module as described above, wherein the bulk conductivity type is the first conductivity type.

According to an embodiment, the present invention relates to the solar panel module as described above, wherein the bulk conductivity type is the second conductivity type and the second electric contact connects to the doped layer of a first conductivity type in the front surface of each semiconductor substrate portion.

According to an embodiment, the present invention relates to the solar panel module as described above, wherein sidewalls of each of the semiconductor substrate portions are exposed.

According to an embodiment, the present invention relates to the solar panel module as described above, wherein sidewalls of each of the semiconductor substrate portions are covered by a doped surface layer of the first conductivity type.

According to an embodiment, the present invention relates to the solar panel module as described above, wherein the doped surface layer on the sidewalls of each of the semiconductor substrate portions is covered by a passivation layer.

According to an embodiment, the present invention relates to the solar panel module as described above, wherein sidewalls of each of the semiconductor substrate portions are covered by a passivation layer.

According to an embodiment, the present invention relates to the solar panel module as described above, wherein a portion of the second electric contact is covered by either the intrinsic semiconductor layer or a passivation layer, and a conductive layer contacts a remainder portion of the second electric contact through an opening in the intrinsic semiconductor layer or the passivation layer, respectively.

According to an embodiment which is not part of the present invention a solar panel module as described above is disclosed, wherein the passivation layer comprises a passivating material selected from a group of silicon nitride, aluminum oxide and silicon dioxide or amorphous silicon, or a stack of passivating material layers or a combination of passivating materials.

Further an embodiment which is not part of the present invention relates to a solar panel module, comprising a transparent carrier, primary and secondary semiconductor substrate portions, each having a front surface and a rear surface, the front surface being arranged in use for capturing radiation energy; the primary and secondary semiconductor substrate portions being arranged in alternation adjacent to each other on the transparent carrier and being separated from each other by a groove, each primary and secondary semiconductor substrate portion being attached with the front surface to the transparent carrier, each groove comprising a side wall of each of the semiconductor substrate portions adjacent to each other; the primary and secondary semiconductor substrate portions being of a bulk conductivity type of a first conductivity type; the front surface of each primary and secondary semiconductor substrate portion being provided with a doped layer of a first conductivity type; a length of the primary semiconductor substrate portion along a surface direction parallel to the transparent carrier surface being relatively longer than a length of the secondary semiconductor substrate portion along that direction, wherein on a first groove disposed on one side of each primary semiconductor substrate portion, a heterojunction of a first type is arranged which comprises a stack of an intrinsic semiconductor material layer and a semiconductor material layer of a second conductivity type, the second conductivity type being opposite to the first conductivity type; and on a second groove disposed on the other side of each primary semiconductor substrate portion a heterojunction of a second type is arranged which comprises a stack of an intrinsic semiconductor material layer and a semiconductor material layer of the first conductivity type; the heterojunction of the first type extending from the first groove on both the rear surface of the primary and the secondary semiconductor substrate portions; the heterojunction of the second type extending from the second groove on both the rear surface of the primary and the secondary semiconductor substrate portions; on the rear surface of the primary semiconductor substrate portion the heterojunction of the first type and the heterojunction of the second type being isolated from each other by a gap in between the semiconductor material layer of the second conductivity type and the semiconductor material layer of the first conductivity type.

According to an embodiment which is not part of the present invention a solar panel module as described above is disclosed, wherein on the rear surface of the secondary semiconductor substrate portion the heterojunction of the first type and the heterojunction of the second type connect to each other; the semiconductor material layer of the second conductivity type and the semiconductor material layer of the first conductivity type abutting each other.

Moreover, the present invention relates to a method for manufacturing a solar panel module comprising:
providing at least one semiconductor substrate, the at least one semiconductor substrate having a bulk conductivity type; texturing the front surface and providing the front surface with a doped layer of a first conductivity type for arranging the front surface for capturing, in use, of radiation energy; providing a transparent carrier; attaching the at least one semiconductor substrate to the transparent carrier, the front surface of the at least one semiconductor substrate facing the transparent carrier; dividing the at least one semiconductor substrate into semiconductor substrate portions; each semiconductor substrate portion having a front surface and a rear surface; the semiconductor substrate portions being arranged adjacent to each other on the transparent carrier and being separated from each other by a groove, each groove comprising a side wall of each of the adjacent semiconductor substrate portions; depositing a layer of intrinsic semiconductor material on the rear surface and on side walls of the grooves;
creating in each semiconductor substrate portion a first electric contact for minority charge carriers in the semiconductor substrate portion and creating a second electric contact for majority charge carriers in the semiconductor substrate portion, wherein the first electric contact is created on at least the rear surface of each semiconductor substrate portion and the first electric contact comprises a heterostructure of a first type, the heterojunction of the first type comprising an intrinsic semiconductor layer on the semiconductor substrate portion and a semiconductor layer of a second conductivity type on top of the intrinsic semiconductor layer, the second conductivity type being opposite to the first conductivity type by depositing the intrinsic semiconductor layer on the semiconductor substrate portion and the semiconductor material layer of a second conductivity type on top of the intrinsic semiconductor layer on at least the rear surface of each semiconductor substrate portion, the second conductivity type being opposite to the first conductivity type.

Advantageously, the grooves divide the silicon wafer into separate adjacent semiconductor substrate portions. By cutting the wafer after attaching it to the transparent carrier, the arrangement of the semiconductor substrate portions is easily obtained without any handling of separate free semiconductor strips.

According to an embodiment, the present invention relates to the method as described above, further comprising: depositing a conductive layer on the rear surface and the grooves; carrying out an isolation process for interrupting the conductive layer between a location of the first electric contact and a location of the second electric contact on each semiconductor substrate portion.

Advantageous embodiments are further defined by the dependent claims.

Below, the invention will be explained with reference to some drawings, which are intended for illustration purposes only and not to limit the scope of protection as defined in the accompanying claims.

### Brief description of drawings

Figure 1 shows a flow diagram for a method of manufacturing a solar panel module according to the present invention;
figure 2 shows a cross-section of a solar panel module according to a first embodiment;
figures 3a - 3c show a cross-section of further examples of a solar panel module according to the first embodiment;
figure 4 shows a cross-section of a solar panel module according to a second embodiment;
figures 5a - 5b show a cross-section of further examples of a solar panel module according to the second embodiment;
figure 6 shows a cross-section of a solar panel module according to a third embodiment;
figures 7a - 7b show a cross-section of further examples of a solar panel module according to the third embodiment.
Figure 8 shows a cross-section of a solar panel module according to a fourth embodiment, and
Figure 9 shows a cross-section of a solar panel module according to a fifth embodiment;
Figures 10a-10c show cross-sections of a solar panel module according to further embodiments.

### Detailed description of embodiments

In the figures as illustrated below, identical reference numbers refer to identical or similar elements.

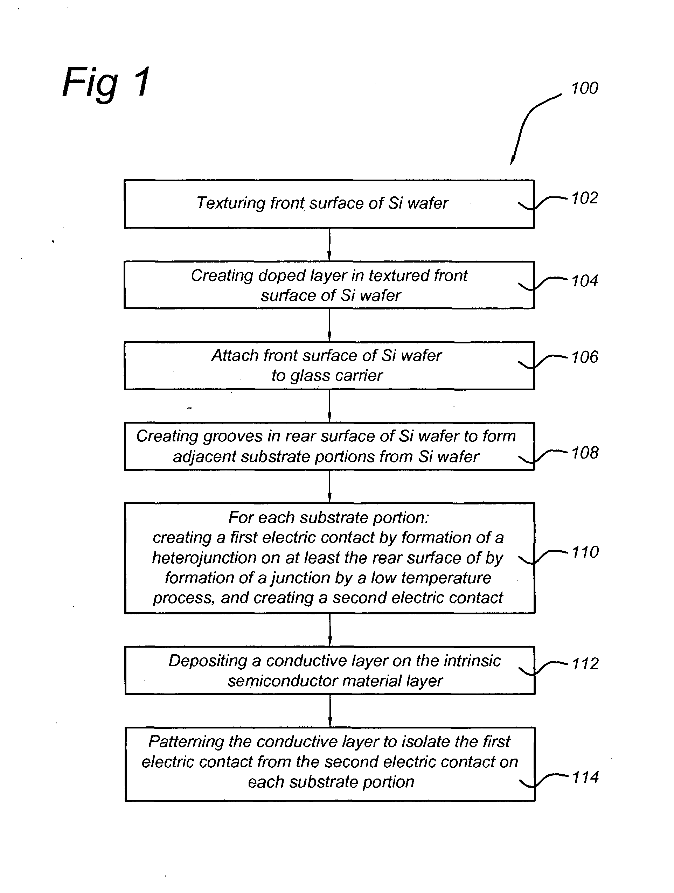

Figure 1 shows a flow diagram for a method of manufacturing a solar panel module according to the present invention.

A processing scheme 100 for manufacturing a solar panel module according to the present invention comprises a sequence of processes.

In an initial process 102, a semiconductor wafer consisting of crystalline silicon is provided. The silicon wafer has a bulk conductivity of a first conductivity type due to intentional doping of the silicon with an impurity species. For example, the first conductivity type is n-type due to doping the silicon crystalline matrix with a donor impurity such as phosphor, antimony or arsenic.

The silicon wafer has a front surface and a rear surface. The front surface will serve as the surface for capturing light from a radiation source such as the sun.

The front surface is treated to enhance the light capturing efficiency, e.g. by texturing. Texturing may comprise an etching process of the front surface.

In a following process 104, a highly doped layer of the first conductivity type is formed in the textured front surface of the silicon wafer. The highly doped layer will serve as a front surface field layer to enhance the lateral conductivity of the majority charge carriers (in the example of n-type bulk conductivity, the majority charge carriers are electrons) and to enhance surface passivation. The term "lateral conductivity" is defined as the conduction of the charge carriers along the textured front surface of the silicon wafer.

Additionally, the front surface of the semiconductor wafer is provided with an anti-reflective coating and a passivation layer, in a manner known from the art.

In a next process 106, a transparent carrier (e.g. a glass plate or a foil layer) is provided and the front surface of the silicon wafer is attached to a surface of the transparent carrier. In an embodiment, the front surface of the silicon wafer is attached to the transparent carrier by an encapsulant layer. The encapsulant layer may comprise a polymeric material including silicones or a ceramic material or a (low-temperature) glass-frit material. In an alternative embodiment, the front surface of the silicon wafer is directly attached to the transparent layer.

Subsequently, in a next process 108, the silicon wafer is divided in a plurality of substrate portions by creating grooves. The grooves can be cut either mechanically by a cutting tool or optically by a laser beam. Also, a lithographic process (using masking and etching) or plasma etching may be conceivable for creating the grooves.

The grooves divide the silicon wafer into separate adjacent semiconductor substrate portions. Grooves may be either wide or narrow. Also, grooves may have tapered side walls or side walls substantially perpendicular to the front surface of the substrate.

In an embodiment, the semiconductor substrate portions have a rectangular base plane attached to the transparent carrier.

By cutting the wafer after attaching it to the transparent carrier, the arrangement of the semiconductor substrate portions is easily obtained without any handling of separate free semiconductor strips.

The tapering of the grooves can be controlled by the cutting process as will be appreciated by the skilled person.

In a subsequent process 110, a layer of intrinsic semiconductor material is deposited on the rear surface of the semiconductor substrate portions and on the side walls of the grooves. This deposition step is followed by a deposition of a layer of semiconductor material of a second conductivity type on the intrinsic semiconductor material layer. The semiconductor material of the second conductivity type is patterned (by masking or etching techniques) to be localized on substantially the rear surface of each semiconductor substrate portion. The second conductivity type is opposite to the first conductivity type. In the example that the first conductivity type is n-type, the second conductivity type is p-type.

The layer of intrinsic semiconductor material may comprise amorphous silicon.

The layer of semiconductor material of the second conductivity type may comprise amorphous silicon containing one or more dopant species of the second conductivity type.

In this manner, a heterojunction of a first type is created substantially on the rear surface of each semiconductor substrate portion as a first electric contact.

Subsequently, on each semiconductor substrate portion a second electric contact is being formed.

According to the invention, the first electric contact is defined by the heterojunction of the first type that is located substantially on the rear surface. In a first embodiment, the second electric contact is a highly doped contact located in or on one of the sidewalls of the semiconductor substrate portion. In a second embodiment, the second electric contact is a highly doped contact located in or on a portion of the rear surface adjacent to the first electric contact. In a third embodiment, the second electric contact is created as a second heterojunction contact of a second type located substantially in or on one of the sidewalls of the semiconductor substrate portion.

In a next process 112, a conductive layer is deposited on the rear surface.

Additionally, an isolation process 114 is carried out to interrupt the conductive layer between the location of the first electric contact and the location of the second electric contact on the semiconductor substrate portion.

Next, further processes (not shown) can be carried out to complete the construction of the solar panel module.

It is noted that the above sequence of processes may comprise other intermediate processes not essential to the invention. Also, the skilled person will appreciate that the order of the described processes may differ from the sequence as described above.

In case the transparent carrier is a foil layer, the carrier is flexible and the semiconductor substrate portions may be formed by controlled breakage or cutting of the semiconductor wafer.

It will be appreciated that the transparent carrier may carry one or more semiconductor substrates that are divided into semiconductor substrate portions. The method is not limited to solar panel module that holds one substrate divided in portions.

Further it is noted that the attaching of the semiconductor substrate to the transparent carrier in an early stage of the process allows to use low-temperature process as from that moment. In stead of forming heterostructures an alternative low-temperature junction formation process may be used such as full area laser scanning which is a laser beam assisted doping process for forming junctions at the rear surface of the semiconductor substrate portions. Due to the small area where junction formation takes place by laser spot heating, the overall thermal budget of this process with respect to the temperature of the full solar cell is low.

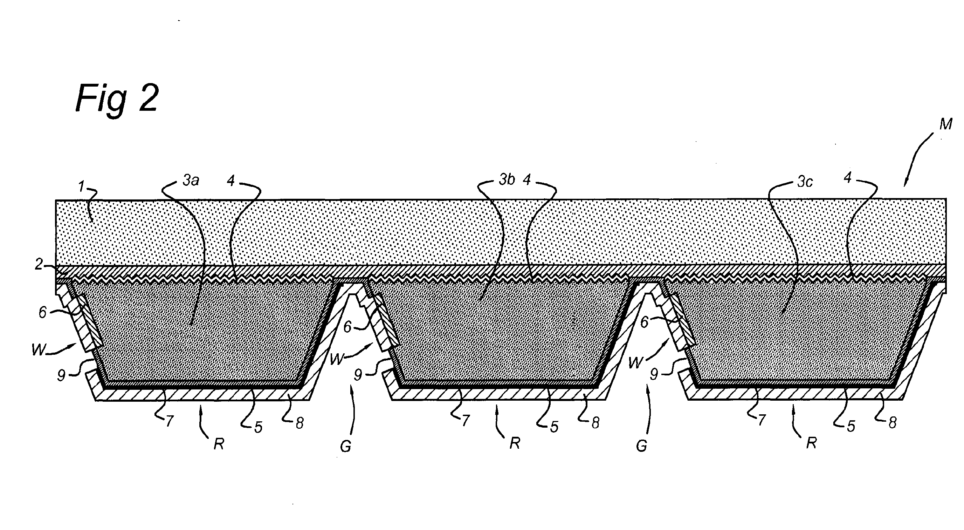

Below, the process flow as described above is described in more detail with reference to the following figures 2 - 9.

In Figure 2 - 9 entities with the same reference number as shown in the preceding figures refer to corresponding entities. For a detailed description of these entities referral is made to the preceding figures and their description.

Figure 2 shows a cross-section of a solar panel module according to a first embodiment.

The solar panel module M manufactured according to the method as described above comprises a transparent carrier (glass plate or glass layer or foil layer) 1 and semiconductor substrate portions 3a, 3b, 3c. The semiconductor substrate portions 3a - 3c have been formed from a semiconductor substrate of a first conductivity type (e.g. n-type) that has been attached to the transparent carrier 1 by an encapsulant layer 2 and subsequently has been cut into portions. The semiconductor substrate portions are separated by cutting grooves G and each comprise a front surface F, a rear surface R and sidewalls W as defined by the grooves G. Each semiconductor substrate portion comprises a front surface layer 4 arranged for receiving radiation energy, which front surface comprises a lightly doped front surface field layer also of the first conductivity type. The dopant level of the front surface layer 4 is relatively high in comparison to the dopant level of the bulk of the silicon wafer, but relatively low in comparison to the typical dopant level of the emitter of a solar cell, as will be appreciated by the skilled person. In practice, the dopant level in the front surface layer is designed so as to enhance conductance along the surface, while a recombination of charge carriers is maintained at very low level (i.e., virtually nil).

An n-type front surface layer can be formed by deposition of phosphor-silicate layer on the front surface, subsequent annealing while the phosphor-silicate layer acts as dopant source to form the front surface layer, and finally removal of the phosphor-silicate layer from the front surface.

In the first embodiment, the rear surface R that is parallel to the front surface F, comprises as first electric contact for minority charge carriers a heterojunction contact 5, 7 of a first type comprising an intrinsic semiconductor material layer 5 and a doped semiconductor material layer 7 of a second conductivity type, opposite to the first conductivity type. The first electric contact covers at least substantially the rear surface. A second electric contact consisting of a highly doped contact area 6 for majority charge carriers is located on one of the sidewalls W of the semiconductor substrate portion. The dopant of the second electric contact has the first conductivity type, similar to the conductivity type of the bulk of the semiconductor substrate portion.

The second electric contact 6 is arranged isolated on the one sidewall W without the necessity for connection to the front surface field layer 4.

Additionally, the first electric contact may cover the sidewall W opposite the sidewall that comprises the second electric contact.

It is noted that the intrinsic semiconductor layer 5 may cover the groove G between adjacent semiconductor substrate portions. The semiconductor material layer 7 of the second conductivity type typically covers at least substantially the rear surface. Additionally, the semiconductor material layer 7 of the second conductivity type may cover the sidewall W that does not comprise the second electric contact 6. The semiconductor material layer 7 of the second conductivity type does not cover the groove in between adjacent semiconductor substrate portions.

The skilled person will appreciate that the semiconductor material layer 7 of the second conductivity type may be shaped/patterned as desired by a suitable lithographical process, comprising masking and/or etching.

On top of the intrinsic semiconductor material layer 5 and/or the semiconductor material layer 7 of the second conductivity type, and the second electric contact 6, a conductive layer 8 is located. The conductive layer 8 may be arranged for connecting a first electric contact of one semiconductor substrate portion 3a and a second electric contact of an adjacent semiconductor substrate portion 3b, located adjacent to the one semiconductor substrate portion 3a.

The conductive layer may comprise a metallic layer (e.g., aluminum and/or silver) and/or a transparent conductive oxide layer (such as indium-tin-oxide or zinc oxide).

On each semiconductor substrate portion 3a, 3b, 3c the conductive layer 8 is interrupted between the location of the second electric contact 6 and the location of the first electric contact 5, 7 by an interrupting element 9. The intrinsic semiconductor material layer 5 may or may not be interrupted by the interrupting element 9.

By connecting adjacent semiconductor substrate portions which are each arranged as solar cell in this manner, a series connection of solar cells is provided to obtain a high voltage solar panel module. The interrupting element 9 may be one of a slit (or gap) and an isolation element. The isolation element typically comprises an insulating (or dielectric) material.

In an example, a solar cell module may have the following dimensions. A thickness of the transparent carrier may be between about 3 and about 4 millimeter. A thickness of the semiconductor substrate and its portions may be between about 50 and about 200 microns. The width of the semiconductor substrate portions may be between about 1000 and about 5000 microns.

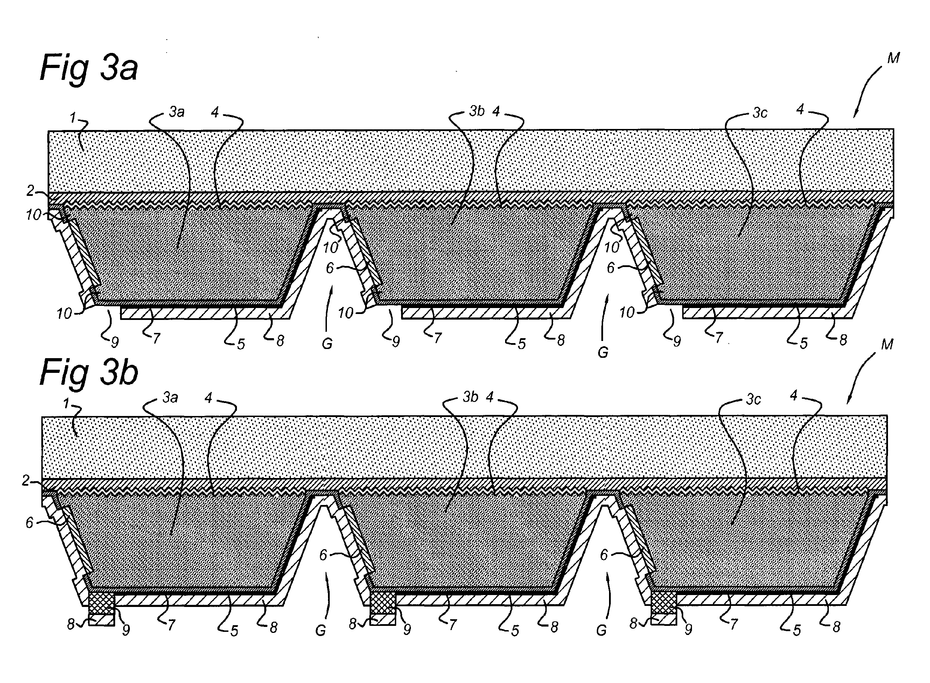

Figures 3a - 3c show a cross-section of further examples of a solar panel module according to the first embodiment.

In Figure 3a, the interrupting element 9 is positioned at a corner between the sidewall that holds the second electric contact 6 and the rear surface. In this manner the second electric contact can be dimensioned to cover most of the sidewall with minimal spacing 10 with either the front surface field layer 4 and/or the rear surface R.

By dimensioning the second electric contact to a maximum area of the sidewall, less accuracy is needed for the manufacturing process. Also, it becomes easier to optimize the contacting resistance of the metal layer.

In Figure 3b the interrupting element 9 is positioned at a corner between the sidewall that holds the second electric contact 6 and the rear surface R and comprises an insulating material to isolate the conductive layer 8 in contact with the second electric contact from the conductive layer in contact with the first electric contact on the same semiconductor substrate portion. In this embodiment, the insulating element 9 is created (by masking and deposition or by deposition and patterning) before the deposition of the conductive layer 8. On top of the insulating element 9 a separate (non-bridging) portion of the conductive layer 8 may be present.

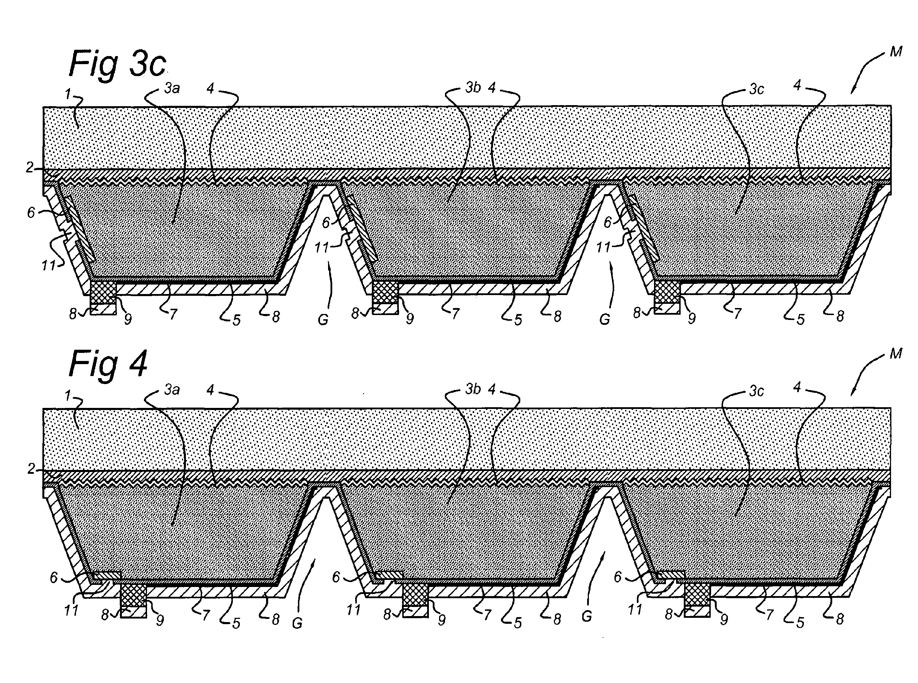

In Figure 3c, the intrinsic semiconductor material layer 5 is deposited so as to extend partially over the second electric contact 6, the intrinsic semiconductor material layer having an opening or gap 11 over at least a portion of the second electric contact 6. The conductive layer 8 is arranged to contact the second electric contact 6 through the opening 11 in the intrinsic semiconductor material layer 5. Advantageously, this embodiment allows an improved passivation for the second electric contact, i.e., the majority charge carrier contact.

Figure 4 shows a cross-section of a solar panel module according to a second embodiment.

In the embodiment shown here, the second electric contact 6 is located on a portion of the rear surface, adjacent to the first electric contact 5, 7, while the interrupting element 9 is located between the first and second electric contacts. As discussed and shown in Figure 3c, the second electric contact 6 is covered by the intrinsic semiconductor material layer 5 with a gap 11 over a portion of the second electric contact 6. Advantageously, in this embodiment, the passivation of the second electric contact is improved.

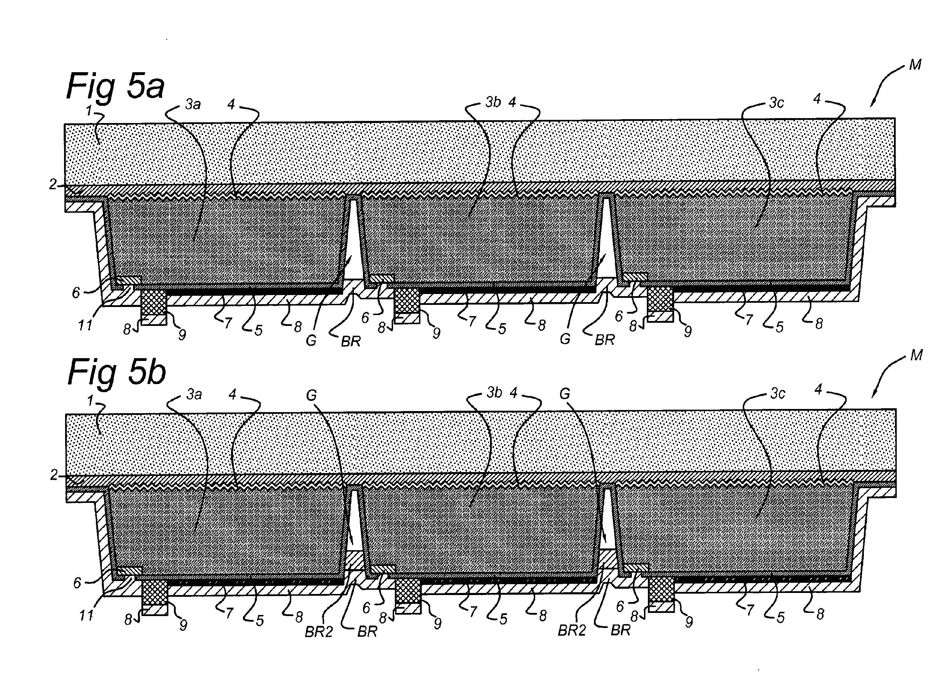

Figures 5a - 5b show a cross-section of further examples of a solar panel module according to the second embodiment.

In Figure 5a - 5b, the grooves G between adjacent semiconductor substrate portions is relatively narrow, which allows to create bridging layers that bridge each groove from one semiconductor substrate portion to the next. The formation of bridging layers can be done in various manners as will be appreciated by the skilled person.

Figure 5a shows a configuration similar to that of Figure 4 which comprises a first electric and a second electric contact both located on the rear surface R of the semiconductor substrate portions. The conductive layer 8 is arranged to bridge the grooves G by means of a bridging element BR.

Figure 5b shows a configuration similar to that of Figure 5a, but here in each groove a separate bridging element BR2 is created to carry the conductive layer across the groove G.

By providing a bridge across each groove, the intrinsic semiconductor material layer 5 and the semiconductor material layer of the second conductivity type may not be deposited in each narrow groove.

In a further embodiment, the groove G is filled with an insulating material, such as silicon dioxide.

In yet a further embodiment, the groove G filled with silicon dioxide is created by a local oxidation process that is capable of forming shaped silicon dioxide regions in the substrate that extend from rear surface to the front surface of the substrate. The shaped silicon dioxide regions are arranged to isolate adjacent substrate portions in the same manner as the groove G. After the creation of the shaped silicon dioxide regions, the bridging element BR is created on the shaped silicon dioxide regions substantially at the level of the rear surface.

In an alternative embodiment, the groove G is filled with an insulating material that is an encapsulating material for encapsulating the solar cell in a solar panel. A solar panel is typically assembled from one or more solar cells that are mounted in a panel frame and encapsulated within the panel frame by a polymer material in order to protect the one or more solar cells against interferences from outside the solar panel, among others.

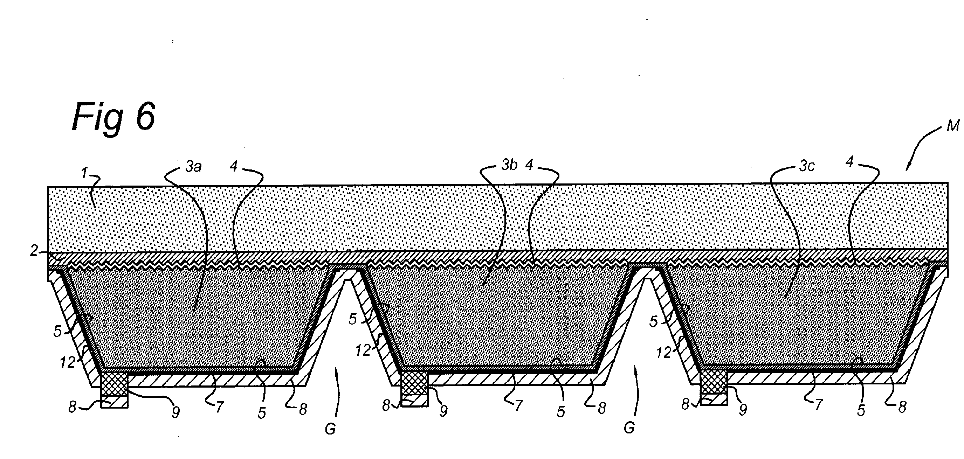

Figure 6 shows a cross-section of a solar panel module according to a third embodiment.

In the third embodiment, both the first and second electric contacts are arranged as heterojunctions of the first and second type, respectively. The second electric contact is a heterojunction structured layer which comprises an intrinsic semiconductor material layer 5 and a semiconductor material layer 12 of the first conductivity type.

In Figure 6, the heterojunction structured layer 5, 12 that embodies the second electric contact is arranged on one of the side walls of each semiconductor substrate portions. The first and second electric contacts are covered by the conductive layer 8, but still isolated by the interrupting element 9.

The interrupting element 9 is located at a corner of the one side wall and the rear surface R to isolate the first electric contact from the second electric contact.

Advantageously, when the contact for the majority carriers is formed in the groove (at the side wall), more area of the rear surface is available for collection of the minority carriers. In addition, the minority carriers do not have to cross the area of the rear surface that would otherwise be occupied by the majority carrier contact.

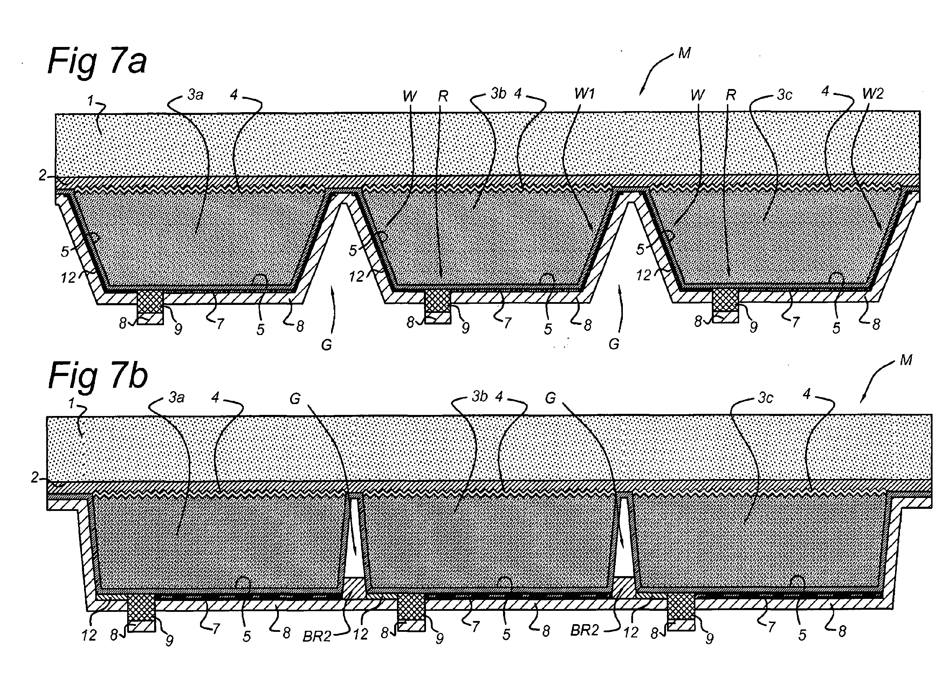

Figures 7a - 7b show a cross-section of further examples of a solar panel module according to the third embodiment.

Figure 7a shows a configuration in which the second electric contact is arranged as heterojunction of the second type covering one side wall W and a portion of the rear surface R and the first electric contact is arranged as heterojunction of the first type covering another portion of the rear surface R and the other side wall W1 of the semiconductor substrate portion. Again, the first and second electric contacts are covered by the conductive layer 8, but still isolated by the interrupting element 9.

The advantage of partial formation of the contacts and isolation on the rear surface is that manufacturing becomes less sensitive to process accuracy compared to the situation that the contact and isolation would have to be strictly limited to the groove and corner, respectively.

Figure 7b shows an alternative configuration in which the grooves between adjacent semiconductor substrate portions is narrow. A bridging element BR is located as bridge between adjacent semiconductor substrate portions. The first electric contact is arranged as heterojunction of the first type covering a portion of the rear surface R and the second electric contact is arranged as heterojunction of the second type covering another portion of the rear surface R of the semiconductor substrate portion. The bridging element BR separates the semiconductor material layer 12 of the first conductivity type of the first electric contact from the semiconductor material layer of the second conductivity type of the second electric contact. As in Figure 7a, the first and second electric contacts are covered by the conductive layer 8, but still isolated by the interrupting element 9. Advantageously, narrower grooves result in a lower loss of silicon and active surface area for photovoltaic conversion. Conductive metal deposition without interruption through the groove (i.e., getting the metal into the groove, covering the groove surface) might be more costly to achieve than bridging a narrow groove. This may also hold for the heterojunction contact of the second type.

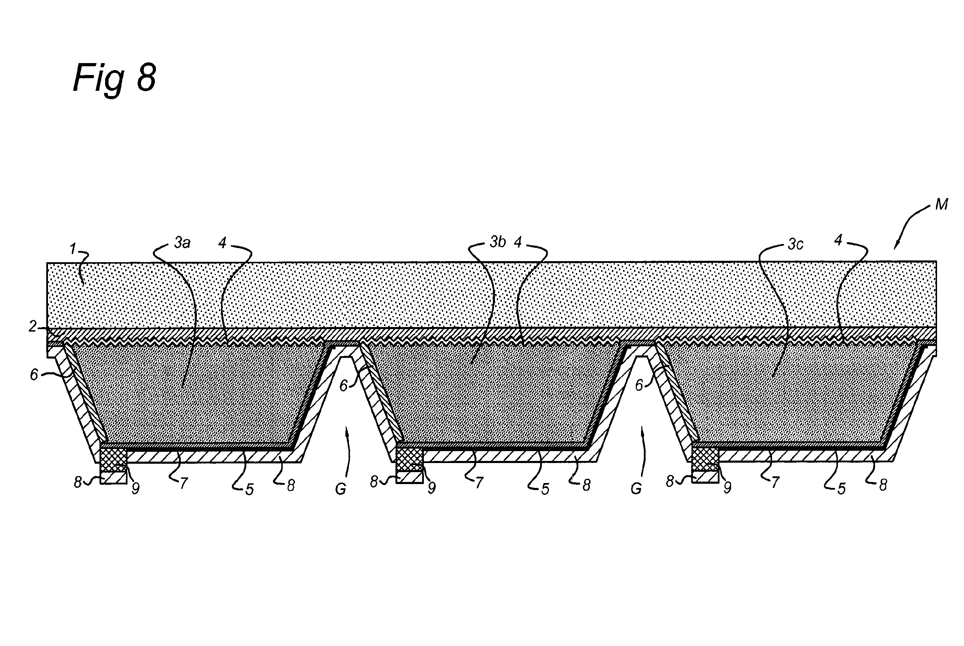

Figure 8 shows a cross-section of a solar panel module according to a fourth embodiment. In this embodiment, the bulk conductivity type is the second conductivity type i.e., p-type. As a result, in use, the minority charge carriers will be collected at the front surface of each of the semiconductor substrate portions. In this embodiment, the second electric contact is a highly doped area 6 of the first conductivity type (n-type) on one sidewall W of the semiconductor substrate portion, and the first electric contact is a heterojunction of the second type (comprising intrinsic semiconductor material layer 5 and semiconductor material layer 7 of second conductivity type, p-type) on at least a portion of the rear surface R and the other sidewall W1.

For enhanced collection of minority charge carriers the second electric contact is connected to the textured front surface field layer 4 which is also of the first conductivity type (n-type). The first and second electric contacts are separated by an interrupting element 9 such as an isolator element. All modifications as shown in relation to the first embodiment may be applied here as well. Moreover, the second electric contact may be embodied also as a heterojunction of the first type on the one sidewall W as described above with reference to Figure 6.

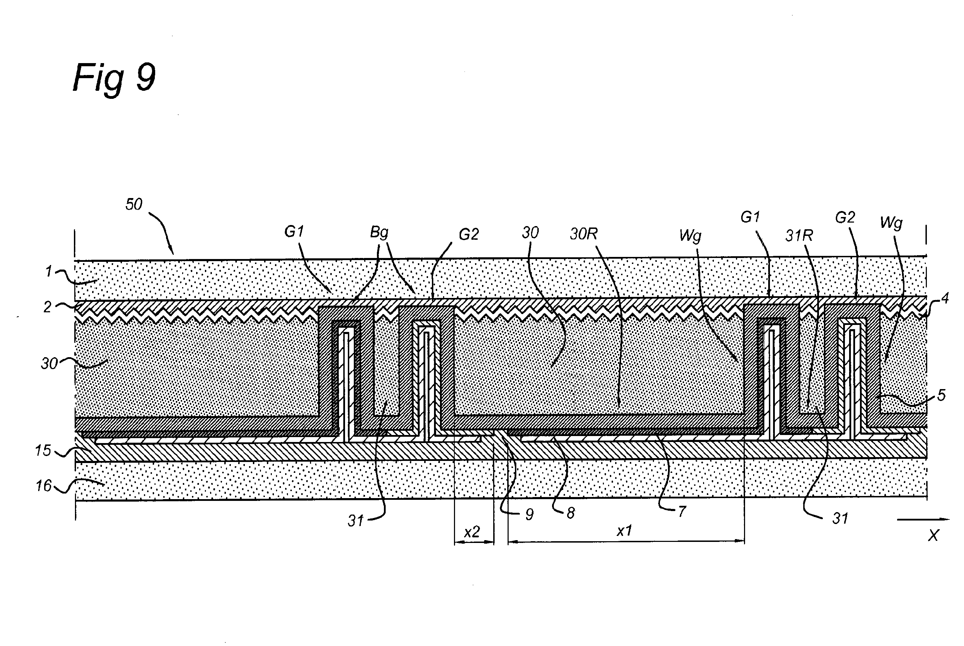

Figure 9 shows a solar panel module according to a fifth embodiment.

In the fifth embodiment, the solar panel module comprises a transparent carrier 1 and a silicon semiconductor substrate. In this embodiment the substrate has a bulk conductivity type equal to the first conductivity type (n-type).

The substrate has a textured surface which is highly doped as first conductivity type to create a front surface field layer 4. The substrate is divided in a plurality of primary and secondary semiconductor substrate portions 30, 31 by grooves G1, G2.

The primary and secondary semiconductor substrate portions 30, 31 are arranged in alternation adjacent to each other on the transparent carrier 1 with the front surface field layer 4 of each substrate portion being directed towards the transparent carrier 1. The primary and secondary semiconductor substrate portions 30, 31 are attached to the transparent carrier 1 by an encapsulant layer 2.

A length of the primary semiconductor substrate portion 30 along a surface direction X parallel to the transparent carrier surface is relatively longer than a length of the secondary semiconductor substrate portion 31 along that direction X.

On sidewalls Wg and bottom Bg of each groove G1, G2 a heterojunction is arranged. On the first groove G1 disposed on one side of each primary semiconductor substrate portion, a heterojunction of a first type is arranged which comprises a stack of an intrinsic semiconductor material layer 5 and a semiconductor material layer 7 of the second conductivity type.

In the second groove G2 on the other side of each primary semiconductor substrate portion a heterojunction of a second type is arranged which comprises a stack of an intrinsic semiconductor material layer 5 and a semiconductor material layer 12 of the first conductivity type.

The heterojunction of the first type is capable of serving as second electric contact for minority charge carriers, while the heterojunction of the second type is capable of serving as first electric contact for majority charge carriers.

The heterojunction of the first type extends from the first groove on both the rear surface of the primary and the secondary semiconductor substrate portions, while the heterojunction of the second type extends from the second groove on both the rear surface of the primary and the secondary semiconductor substrate portions.

The primary semiconductor substrate portion 30 is characterized by the fact that on its rear surface 30r, the heterojunction of the first type and the heterojunction of the second type are isolated from each other by a gap 9 in the semiconductor material layer 7 of the second conductivity type and the semiconductor material layer 12 of the first conductivity type.

The secondary semiconductor substrate portion 31 is characterized by the fact that on its rear surface 31r, the heterojunction of the first type and the heterojunction of the second type connect to each other; the semiconductor material layer 7 of the second conductivity type and the semiconductor material layer 12 of the first conductivity type abut each other.

On top of the heterojunction of the first type and the heterojunction of the second type a conductive layer 8 is arranged, which is interrupted at the gap 9 on the rear surface 30r of each primary semiconductor substrate portion 30.

In this manner a series connection of adjacent semiconductor substrate portions is obtained in which advantageously recombination of minority and majority charge carriers is strongly reduced.

In the fifth embodiment, the bulk conductivity type of the semiconductor substrate portions is preferably the first conductivity type. In a further embodiment, the first conductivity type is preferably n-type.

In the fifth embodiment, the grooves G1, G2 may be either wide or narrow and may have tapered side walls or side walls substantially perpendicular to the front surface.

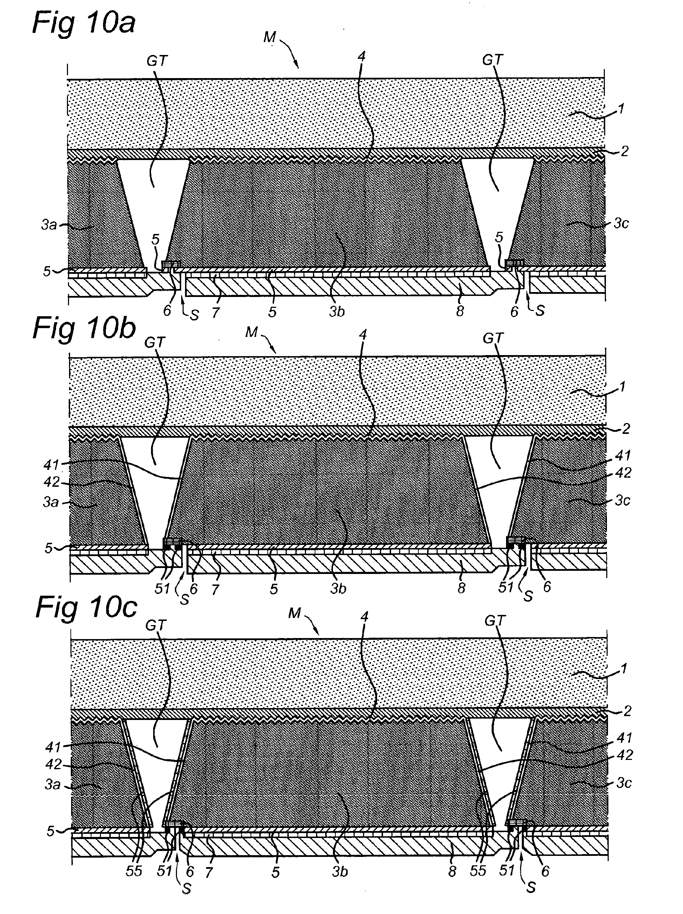

Figures 10a-10c show cross-sections of a solar panel module M according to further embodiments.

According to a further embodiment, the groove GT between adjacent semiconductor substrate portions 3a, 3b; 3b, 3c tapers in the direction away from the transparent carrier 1 towards the rear surface side of the substrate portions.

In the embodiments shown in figures 10a-10c the second electric contact 6 is a highly doped region on a portion of the rear surface of each semiconductor substrate portion 3a; 3b; 3c adjacent to the first electric contact 5, 7. The first electric contact 5, 7 is embodied by the heterojunction of the first type as described above in more detail.

The skilled person will appreciate that alternatively the second electric contact 6 may be embodied as a heterojunction of the second type as described with reference to figure 7b.

Each semiconductor substrate portion comprises the front surface layer 4 arranged for receiving radiation energy, which front surface layer comprises a (lightly) doped front surface field layer also of the first conductivity type.

The electrical series connection between each pair of adjacent semiconductor substrate portions is embodied by the conductive layer 8, which connects the first electric contact of one semiconductor substrate portion to the second electric contact of the adjacent semiconductor substrate portion. The conductive layer 8 is interrupted by slits S or interrupting elements 9 between the first electric contact 5,7 and second electric contact 6 on each semiconductor substrate portion 3a; 3b; 3c.

Preferably, the conductive layer 8 comprises a bridging part BR that bridges the tapered groove GT between the two semiconductor substrate portions.

In the embodiment as shown in figure 10a, the intrinsic semiconductor layer 5 of the heterojunction 5, 7 covers also the second electric contact 6. The conductive layer 8 contacts the second electric contact through an opening in the intrinsic semiconductor layer 5. In this embodiment, the sidewalls of each semiconductor substrate portions are exposed.

It is noted that alternatively, the area of the second electric contact may be exposed, free from intrinsic semiconductor material 5. In that case, the conductive layer 8 may contact the region of the second electric contact 6 directly.

Figure 10b shows a further embodiment of the solar panel module M with tapered grooves GT, in which the sidewalls of the semiconductor substrate portions are covered by a doped surface layer 41, 42 which basically is an extension of the front surface field layer 4. Both front surface and sidewall layers 4, 41, 42 are of the same first conductivity type.

The arrangement of the second electric contact 6 may be the same as in figure 10a, with a partial coverage of the area of the second electric contact with the intrinsic semiconductor layer 5. In the embodiment shown in figure 10b, the area of the second electric contact is covered partially by a further passivation layer 51, that comprises a passivating material selected from a group of silicon nitride, aluminum oxide and silicon dioxide or amorphous silicon or another passivating material or material combination, e.g. stacked layers ofpassivating materials. The conductive layer 8 is arranged to contact the second electric contact through an opening in the passivation layer 51.

The skilled person will appreciate that application of such a passivation layer 51, is not limited to the specific embodiment shown in figure 10b, but may be applied in each of the embodiments described above.

Figure 10c shows a further embodiment of the solar panel module M with tapered grooves GT, in which the sidewalls of the semiconductor substrate portions are covered by a stack of the doped surface layer 41, 42 and a passivation layer 55. The doped surface layers 41, 42 cover the sidewalls of the semiconductor substrate portions, while the passivation layer 55 covers the doped surface layer 41, 42. Application of the passivation layer 55 on the doped surface layer reduces the recombination probability of majority and minority charge carriers in the doped surface layers.

It is noted that the passivation layer 55 may also be applied directly on the exposed sidewalls of the semiconductor substrate portions as shown in figure 10a.

The passivation layer 55 may comprise a passivating material selected from a group of silicon nitride, aluminum oxide and silicon dioxide or amorphous silicon or any other passivating material, material combination or stack of passivating material layers.

Further it is noted that the tapered grooves GT may be (partially) filled with an insulating material such as EVA (Ethylene vinyl acetate) or silicones or PVB (Polyvinyl butyral) or any other encapsulant material.

In a further embodiment, such insulating material in the grooves may be an encapsulation material e.g. a polymer, as used for encapsulating solar cells in a solar panel frame.

Additionally, it will be appreciated that the embodiments shown in figures 10a - 10c may also be implemented in solar panel modules with perpendicular grooves or grooves tapered in a direction from the rear surface side of the semiconductor substrate portions towards the transparent carrier 1, e.g. as in figure 4.

The clauses 1-6, 9-15, 17-26, 30-31 define various aspects of the present invention.
Clause 1. A solar panel module comprising:
   a transparent carrier, silicon semiconductor substrate portions, having a front surface and a rear surface, the front surface being arranged in use for capturing radiation energy;
   the semiconductor substrate portions being arranged adjacent to each other on the transparent carrier and being separated from each other by a groove, each semiconductor substrate portion being attached with the front surface to the transparent carrier, each groove comprising a side wall of each of the semiconductor substrate portions adjacent to each other;
   the semiconductor substrate portions being of a bulk conductivity type;
   the front surface of each semiconductor substrate portion being provided with a doped layer of a first conductivity type;
   each semiconductor substrate portion comprising a first electric contact for minority charge carriers in the semiconductor substrate portion and a second electric contact for majority charge carriers in the semiconductor substrate portion;
   the first electric contact being arranged on at least the rear surface of the semiconductor substrate portion, wherein the first electric contact is a heterostructure of a first type, the heterojunction of the first type comprising an intrinsic semiconductor layer on the semiconductor substrate portion and a semiconductor layer of a second conductivity type on top of the intrinsic semiconductor layer, the second conductivity type being opposite to the first conductivity type.
Clause 2. The solar panel according to clause 1, wherein the layer of intrinsic semiconductor material comprises amorphous silicon.
Clause 3. The solar panel according to clause 1 or clause 2, wherein the layer of semiconductor material of the second conductivity type comprises amorphous silicon containing one or more dopant species, resulting in the second conductivity type.
Clause 4. The solar cell according to any one of the preceding clauses, wherein the intrinsic semiconductor layer covers the groove between adjacent semiconductor substrate portions.
Clause 5. The solar cell according to clause 4, wherein the semiconductor material layer of the second conductivity type covers at least substantially the rear surface.
Clause 6. The solar cell according to clause 5, wherein the semiconductor material layer of the second conductivity type covers the sidewall of the semiconductor substrate portion that does not comprise the second electric contact.
Clause 7. The solar cell according to any one of the preceding clauses, wherein the front surface of the semiconductor substrate portions is provided with an anti-reflective coating and a passivation layer.
Clause 8. The solar panel module according to according to any one of the preceding clauses, wherein the first electric contact is a junction formed by a low-temperature junction formation process.
Clause 9. The solar panel module according to any one of the preceding clauses 1 - 8, wherein the second electric contact is a highly doped contact area of the first conductivity type, in one side wall of the semiconductor substrate portion.
Clause 10. The solar panel module according to any one of the preceding clauses 1 - 8, wherein the second electric contact is a highly doped contact area of the first conductivity type, in a portion of the rear surface of the semiconductor substrate portion adjacent to the first electric contact.
Clause 11. The solar panel module according to any one of the preceding clauses 1 - 8, wherein the second electric contact is a heterojunction of a second type, the heterojunction of the second type comprising an intrinsic semiconductor layer and a semiconductor layer of the first conductivity type, substantially on one side wall of the semiconductor substrate portion.
Clause 12. The solar panel module according to any one of the preceding clauses, wherein a conductive layer is arranged on the rear surface and side walls of each semiconductor substrate portion, and wherein on each semiconductor substrate portion the conductive layer comprises an interrupting element between the location of the first electric contact and the location of the second electric contact.
Clause 13. The solar panel module according to clause 12, wherein the interrupting element is either a slit in the conductive layer or an isolator step element in the conductive layer.
Clause 14. The solar panel module according to clause 12 or clause 13 as far as dependent on clause 9 or clause 10, wherein a passivation layer is arranged on the highly doped contact area, the passivation layer having an opening for exposure of at least a portion of the highly doped contact area for connection with the conductive layer.
Clause 15. The solar panel module according to clause 10, wherein the groove between adjacent semiconductor substrate portions is filled with an insulating material.
Clause 16. The solar panel module according to clause 15, wherein the insulating material is an encapsulating material for encapsulating the solar cell in a solar panel.
Clause 17. The solar panel module according to clause 10 or clause 15, wherein the groove between adjacent semiconductor substrate portions is bridged by a bridging element.
Clause 18. The solar panel according to any one of the preceding clauses, wherein the groove is tapered in a direction from the transparent carrier towards the rear surface side of the semiconductor substrate portions.
Clause 19. The solar panel according to any one of the preceding clauses, wherein the groove is either perpendicular to the rear surface or tapered in a direction from the rear surface side of the semiconductor substrate portions towards the transparent carrier.
Clause 20. The solar panel module according to any one of the preceding clauses, wherein the bulk conductivity type is the first conductivity type.
Clause 21. The solar panel module according to clause 4, wherein the bulk conductivity type is the second conductivity type and the second electric contact connects to the doped layer of a first coriductivity type in the front surface of each semiconductor substrate portion.
Clause 22. The solar panel according to clause 18 or clause 19, wherein sidewalls of each of the semiconductor substrate portions are exposed.
Clause 23. The solar panel according to clause 18 or clause 19, wherein sidewalls of each of the semiconductor substrate portions are covered by a doped surface layer of the first conductivity type.
Clause 24. The solar panel according to clause 23, wherein the doped surface layer on the sidewalls of each of the semiconductor substrate portions is covered by a passivation layer.
Clause 25. The solar panel according to clause 18 or clause 19, wherein sidewalls of each of the semiconductor substrate portions are covered by a passivation layer.
Clause 26. The solar panel according to clause 9 or clause 10, wherein a portion of the second electric contact is covered by either the intrinsic semiconductor layer or a passivation layer, and a conductive layer contacts a remainder portion of the second electric contact through an opening in the intrinsic semiconductor layer or the passivation layer, respectively.
Clause 27. The solar panel according to any one of the preceding clauses 24 - 26, wherein the passivation layer comprises a passivating material selected from a group of silicon nitride, aluminum oxide and silicon dioxide or amorphous silicon, or a stack of passivating material layers or a combinations of passivating materials.
Clause 28. A solar panel module, comprising
   a transparent carrier, primary and secondary semiconductor substrate portions, each having a front surface and a rear surface, the front surface being arranged in use for capturing radiation energy; the primary and secondary semiconductor substrate portions being arranged in alternation adjacent to each other on the transparent carrier and being separated from each other by a groove, each primary and secondary semiconductor substrate portion being attached with the front surface to the transparent carrier, each groove comprising a side wall of each of the semiconductor substrate portions adjacent to each other; the primary and secondary semiconductor substrate portions being of a bulk conductivity type of a first conductivity type; the front surface of each primary and secondary semiconductor substrate portion being provided with a doped layer of a first conductivity type; a length of the primary semiconductor substrate portion along a surface direction parallel to the transparent carrier surface being relatively longer than a length of the secondary semiconductor substrate portion along that direction, wherein on a first groove disposed on one side of each primary semiconductor substrate portion, a heterojunction of a first type is arranged which comprises a stack of an intrinsic semiconductor material layer and a semiconductor material layer of a second conductivity type, the second conductivity type being opposite to the first conductivity type; and on a second groove disposed on the other side of each primary semiconductor substrate portion a heterojunction of a second type is arranged which comprises a stack of an intrinsic semiconductor material layer and a semiconductor material layer of the first conductivity type; the heterojunction of the first type extending from the first groove on both the rear surface of the primary and the secondary semiconductor substrate portions; the heterojunction of the second type extending from the second groove on both the rear surface of the primary and the secondary semiconductor substrate portions; on the rear surface of the primary semiconductor substrate portion the heterojunction of the first type and the heterojunction of the second type being isolated from each other by a gap in between the semiconductor material layer of the second conductivity type and the semiconductor material layer of the first conductivity type.
Clause 29. The solar panel module according to clause 28, wherein on the rear surface of the secondary semiconductor substrate portion the heterojunction of the first type and the heterojunction of the second type connect to each other; the semiconductor material layer of the second conductivity type and the semiconductor material layer of the first conductivity type abutting each other.
Clause 30. A method for manufacturing a solar panel module comprising: providing at least one semiconductor substrate, the at least one semiconductor substrate having a bulk conductivity type; texturing the front surface and providing the front surface with a doped layer of a first conductivity type for arranging the front surface for capturing, in use, of radiation energy; providing a transparent carrier; attaching the at least one semiconductor substrate to the transparent carrier, the front surface of the at least one semiconductor substrate facing the transparent carrier; dividing the at least one semiconductor substrate into semiconductor substrate portions; each semiconductor substrate portion having a front surface and a rear surface; the semiconductor substrate portions being arranged adjacent to each other on the transparent carrier and being separated from each other by a groove, each groove comprising a side wall of each of the adjacent semiconductor substrate portions; depositing a layer of intrinsic semiconductor material on the rear surface and on side walls of the grooves; creating in each semiconductor substrate portion a first electric contact for minority charge carriers in the semiconductor substrate portion and creating a second electric contact for majority charge carriers in the semiconductor substrate portion, wherein the first electric contact is created on at least the rear surface of each semiconductor substrate portion and the first electric contact comprises a heterostructure of a first type, the heterojunction of the first type comprising an intrinsic semiconductor layer on the semiconductor substrate portion and a semiconductor layer of a second conductivity type on top of the intrinsic semiconductor layer, the second conductivity type being opposite to the first conductivity type by depositing the intrinsic semiconductor layer on the semiconductor substrate portion and the semiconductor material layer of a second conductivity type on top of the intrinsic semiconductor layer on at least the rear surface of each semiconductor substrate portion, the second conductivity type being opposite to the first conductivity type.
Clause 31. The method according to clause 30, further comprising: depositing a conductive layer on the rear surface and the grooves; carrying out an isolation process for interrupting the conductive layer between a location of the first electric contact and a location of the second electric contact on each semiconductor substrate portion.

## Claims

1. A solar panel module (M) comprising:
a transparent carrier (1) silicon semiconductor substrate portions (3a,3b,3c) having a front surface (F) and a rear surface (R), the front surface being arranged in use for capturing radiation energy;
the semiconductor substrate portions being arranged adjacent to each other on the transparent carrier and being separated from each other by a groove (G), each semiconductor substrate portion being attached with the front surface to the transparent carrier, each groove comprising a side wall (W) of each of the semiconductor substrate portions adjacent to each other;
the semiconductor substrate portions being of a bulk conductivity type;
the front surface of each semiconductor substrate portion being provided with a doped layer (4) of a first conductivity type;
each semiconductor substrate portion comprising a first electric contact (5,7) for minority charge carriers in the semiconductor substrate portion and a second electric contact (6) for majority charge carriers in the semiconductor substrate portion;
the first electric contact being arranged on at least the rear surface of the semiconductor substrate portion, wherein the first electric contact is a heterostructure of a first type, the heterojunction of the first type comprising an intrinsic semiconductor layer (7) on the semiconductor substrate portion and a semiconductor layer of a second conductivity type on top of the intrinsic semiconductor layer, the second conductivity type being opposite to the first conductivity type.

2. The solar panel according to claim 1, wherein the layer of intrinsic semiconductor material comprises amorphous silicon.

3. The solar panel according to claim 1 or claim 2, wherein the layer of semiconductor material of the second conductivity type comprises amorphous silicon containing one or more dopant species, resulting in the second conductivity type.

4. The solar cell according to any one of the preceding claims, wherein the intrinsic semiconductor layer covers the groove between adjacent semiconductor substrate portions.

5. The solar cell according to claim 4, wherein the semiconductor material layer of the second conductivity type covers at least substantially the rear surface.

6. The solar cell according to claim 5, wherein the semiconductor material layer of the second conductivity type covers the sidewall of the semiconductor substrate portion that does not comprise the second electric contact.

7. The solar panel module according to any one of the preceding claims 1 - 6, wherein the second electric contact is a highly doped contact area of the first conductivity type, in one side wall of the semiconductor substrate portion.

8. The solar panel module according to any one of the preceding claims 1 - 6, wherein the second electric contact is a highly doped contact area of the first conductivity type, in a portion of the rear surface of the semiconductor substrate portion adjacent to the first electric contact.

9. The solar panel module according to any one of the preceding claims 1 - 6, wherein the second electric contact is a heterojunction of a second type, the heterojunction of the second type comprising an intrinsic semiconductor layer and a semiconductor layer of the first conductivity type, substantially on one side wall of the semiconductor substrate portion.

10. The solar panel module according to any one of the preceding claims, wherein a conductive layer is arranged on the rear surface and side walls of each semiconductor substrate portion, and wherein on each semiconductor substrate portion the conductive layer comprises an interrupting element between the location of the first electric contact and the location of the second electric contact.

11. The solar panel module according to claim 10, wherein the interrupting element is either a slit in the conductive layer or an isolator step element in the conductive layer.

12. The solar panel module according to claim 10 or claim 11 as far as dependent on claim 7 or claim 8, wherein a passivation layer is arranged on the highly doped contact area, the passivation layer having an opening for exposure of at least a portion of the highly doped contact area for connection with the conductive layer.

13. The solar panel module according to claim 8, wherein the groove between adjacent semiconductor substrate portions is filled with an insulating material.

14. The solar panel module according to claim 8 or claim 13, wherein the groove between adjacent semiconductor substrate portions is bridged by a bridging element.

15. The solar panel according to any one of the preceding claims, wherein the groove is tapered in a direction from the transparent carrier towards the rear surface side of the semiconductor substrate portions.

16. The solar panel according to any one of the preceding claims, wherein the groove is either perpendicular to the rear surface or tapered in a direction from the rear surface side of the semiconductor substrate portions towards the transparent carrier.

17. The solar panel module according to any one of the preceding claims, wherein the bulk conductivity type is the first conductivity type.

18. The solar panel module according to claim 4, wherein the bulk conductivity type is the second conductivity type and the second electric contact connects to the doped layer of a first conductivity type in the front surface of each semiconductor substrate portion.

19. The solar panel according to claim 15 or claim 16, wherein sidewalls of each of the semiconductor substrate portions are exposed.

20. The solar panel according to claim 15 or claim 16, wherein sidewalls of each of the semiconductor substrate portions are covered by a doped surface layer of the first conductivity type.

21. The solar panel according to claim 20, wherein the doped surface layer on the sidewalls of each of the semiconductor substrate portions is covered by a passivation layer.

22. The solar panel according to claim 15 or claim 16, wherein sidewalls of each of the semiconductor substrate portions are covered by a passivation layer.

23. The solar panel according to claim 7 or claim 8, wherein a portion of the second electric contact is covered by either the intrinsic semiconductor layer or a passivation layer, and a conductive layer contacts a remainder portion of the second electric contact through an opening in the intrinsic semiconductor layer or the passivation layer, respectively.

24. A method for manufacturing a solar panel module (M) comprising:
providing at least one semiconductor substrate, the at least one semiconductor substrate having a bulk conductivity type; texturing the front surface and providing the front surface with a doped layer (4) of a first conductivity type for arranging the front surface for capturing, in use, of radiation energy; providing a transparent carrier (1) attaching the at least one semiconductor substrate to the transparent carrier, the front surface of the at least one semiconductor substrate facing the transparent carrier; dividing the at least one semiconductor substrate into semiconductor substrate portions (3a,3b,3c) each semiconductor substrate portion having a front surface (F) and a rear surface (R), the semiconductor substrate portions being arranged adjacent to each other on the transparent carrier and being separated from each other by a groove (G) each groove comprising a side wall (W) of each of the adjacent semiconductor substrate portions; depositing a layer of intrinsic semiconductor material (5) on the rear surface and on side walls of the grooves;
creating in each semiconductor substrate portion a first electric contact for minority charge carriers in the semiconductor substrate portion and creating a second electric contact for majority charge carriers in the semiconductor substrate portion, wherein the first electric contact is created on at least the rear surface of each semiconductor substrate portion and the first electric contact comprises a heterostructure of a first type, the heterojunction of the first type comprising an intrinsic semiconductor layer (5) on the semiconductor substrate portion and a semiconductor layer (7) of a second conductivity type on top of the intrinsic semiconductor layer, the second conductivity type being opposite to the first conductivity type by depositing the intrinsic semiconductor layer on the semiconductor substrate portion and the semiconductor material layer of a second conductivity type on top of the intrinsic semiconductor layer on at least the rear surface of each semiconductor substrate portion, the second conductivity type being opposite to the first conductivity type.

25. The method according to claim 24, further comprising: depositing a conductive layer on the rear surface and the grooves; carrying out an isolation process for interrupting the conductive layer between a location of the first electric contact and a location of the second electric contact on each semiconductor substrate portion.

## Patentansprüche

1. Solarpanel-Modul (M), das umfasst:
einen transparenten Träger (1), Halbleitersubstrat-Abschnitte aus Silizium (3a, 3b, 3c), die eine Vorderseite (F) und eine Rückseite (R) haben, wobei die Vorderseite so eingerichtet ist, dass sie Strahlungsenergie einfängt;
die Halbleitersubstrat-Abschnitte nebeneinander auf dem transparenten Träger angeordnet sind und voneinander durch eine Nut (G) getrennt werden, wobei jeder HalbleitersubstratAbschnitt mit der Vorderseite an dem transparenten Träger angebracht ist und jede Nut eine Seitenwand (W) jedes der nebeneinander befindlichen Halbleitersubstrat-Abschnitte umfasst;
die Halbleitersubstrat-Abschnitte vom Volumenleitfähigkeitstyp sind;
die Vorderseite jedes Halbleitersubstrat-Abschnitts mit einer dotierten Schicht (4) eines ersten Leitfähigkeitstyps versehen ist;
jeder Halbleitersubstratabschnitt einen ersten elektrischen Kontakt (5, 7) für Minoritätsladungsträger in dem Halbleitersubstrat-Abschnitt und einen zweiten elektrischen Kontakt (6) für Majoritätsladungsträger in dem Halbleitersubstrat-Abschnitt umfasst;
der erste elektrische Kontakt wenigstens an der Rückseite des Halbleitersubstrat-Abschnitts angeordnet ist, wobei der erste elektrische Kontakt eine Heterostruktur eines ersten Typs ist, der Heteroübergang des ersten Typs eine Eigenhalbleiterschicht (7) auf dem Halbleitersubstrat-Abschnitt sowie eine Halbleiterschicht eines zweiten Leitfähigkeitstyps über der Eigenhalbleiterschicht umfasst, und der zweite Leitfähigkeitstyp dem ersten Leitfähigkeitstyp entgegengesetzt ist.

2. Solarpanel nach Anspruch 1, wobei die Schicht aus Eigenhalbleitermaterial amorphes Silizium umfasst.

3. Solarpanel nach Anspruch 1 oder Anspruch 2, wobei die Schicht aus Halbleitermaterial des zweiten Leitfähigkeitstyps amorphes Silizium umfasst, das eine oder mehrere Dotierungssubstanz/en enthält, wodurch sich der zweite Leitfähigkeitstyp ergibt.

4. Solarzelle nach einem der vorangehenden Ansprüche, wobei die Eigenhalbleiterschicht die Nut zwischen nebeneinander befindlichen Halbleitersubstrat-Abschnitten abdeckt.

5. Solarzelle nach Anspruch 4, wobei die Halbleitermaterialschicht des zweiten Leitfähigkeitstyps wenigstens im Wesentlichen die Rückseite abdeckt.

6. Solarzelle nach Anspruch 5, wobei die Halbleitermaterialschicht des zweiten Leitfähigkeitstyps die Seitenwand des Halbleitersubstrat-Abschnitts abdeckt, die den zweiten elektrischen Kontakt nicht umfasst.

7. Solarpanel-Modul nach einem der vorangehenden Ansprüche 1-6, wobei der zweite elektrische Kontakt ein hochdotierter Kontaktbereich des ersten Leitfähigkeitstyps in einer Seitenwand des Halbleitersubstrat-Abschnitts ist.

8. Solarpanel-Modul nach einem der vorangehenden Ansprüche 1-6, wobei der zweite elektrische Kontakt ein hochdotierter Kontaktbereich des ersten Leitfähigkeitstyps in einem Abschnitt der Rückseite des Halbleitersubstrat-Abschnitts ist, der an den ersten elektrischen Kontakt angrenzt.

9. Solarpanel-Modul nach einem der vorangehenden Ansprüche 1-6, wobei der zweite elektrische Kontakt ein Heteroübergang eines zweiten Typs ist, der Heteroübergang des zweiten Typs eine Eigenhalbleiterschicht und eine Halbleiterschicht des ersten Leitfähigkeitstyps im Wesentlichen an einer Seitenwand des Halbleitersubstrat-Abschnitts umfasst.

10. Solarpanel-Modul nach einem der vorangehenden Ansprüche, wobei eine leitende Schicht an der Rückseite und Seitenwänden jedes Halbleitersubstrat-Abschnitts angeordnet ist und an jedem Halbleitersubstrat-Abschnitt die leitende Schicht ein unterbrechendes Element zwischen der Position des ersten elektrischen Kontaktes und der Position des zweiten elektrischen Kontaktes umfasst.

11. Solarpanel-Modul nach Anspruch 10, wobei das unterbrechende Element entweder ein Schlitz in der leitenden Schicht oder ein Isolator-Absatzelement in der leitenden Schicht ist.

12. Solarpanel-Modul nach Anspruch 10 oder Anspruch 11, sofern abhängig von Anspruch 7 oder Anspruch 8, wobei eine Passivierungsschicht auf dem hochdotierten Kontaktbereich angeordnet ist und die Passivierungsschicht eine Öffnung aufweist, über die wenigstens ein Abschnitt des hochdotierten Kontaktbereiches zur Verbindung mit der leitenden Schicht freiliegt.

13. Solarpanel-Modul nach Anspruch 8, wobei die Nut zwischen nebeneinander befindlichen Halbleitersubstrat-Abschnitten mit einem isolierenden Material gefüllt ist.

14. Solarpanel-Modul nach Anspruch 8 oder Anspruch 13, wobei die Nut zwischen nebeneinander befindlichen Halbleitersubstrat-Abschnitten von einem Überbrückungselement überbrückt wird.

15. Solarpanel nach einem der vorangehenden Ansprüche, wobei sich die Nut in einer Richtung von dem transparenten Träger zu der Rückseite der Halbleitersubstrat-Abschnitte hin verjüngt.

16. Solarpanel nach einem der vorangehenden Ansprüche, wobei die Nut entweder senkrecht zu der Rückseite ist oder sich in einer Richtung von der Rückseite der HalbleitersubstratAbschnitte zu dem transparenten Träger hin verjüngt.

17. Solarpanel-Modul nach einem der vorangehenden Ansprüche, wobei der Volumenleitfähigkeitstyp der erste Leitfähigkeitstyp ist.

18. Solarpanel-Modul nach Anspruch 4, wobei der Volumenleitfähigkeitstyp der zweite Leitfähigkeitstyp ist und der zweite elektrische Kontakt mit der dotierten Schicht eines ersten Leitfähigkeitstyps an der Vorderseite jedes Halbleitersubstrat-Abschnitts verbunden ist.

19. Solarpanel nach Anspruch 15 oder Anspruch 16, wobei Seitenwände jedes der Halbleitersubstrat-Abschnitte freiliegen.

20. Solarpanel nach Anspruch 15 oder Anspruch 16, wobei Seitenwände jedes der Halbleitersubstrat-Abschnitte von einer dotierten Oberflächenschicht des ersten Leitfähigkeitstyps abgedeckt werden.

21. Solarpanel nach Anspruch 20, wobei die dotierte Oberflächenschicht an den Seitenwänden der Halbleitersubstrat-Abschnitte von einer Passivierungsschicht abgedeckt wird.

22. Solarpanel nach Anspruch 15 oder Anspruch 16, wobei Seitenwände jedes der Halbleitersubstrat-Abschnitte von einer Passivierungsschicht abgedeckt werden.

23. Solarpanel nach Anspruch 7 oder Anspruch 8, wobei ein Abschnitt des zweiten elektrischen Kontakts entweder von der Eigenhalbleiterschicht oder einer Passivierungsschicht abgedeckt wird und eine leitende Schicht mit einem verbleibenden Abschnitt des zweiten elektrischen Kontakts über eine Öffnung in der Eigenhalbleiterschicht bzw. der Passivierungsschicht in Kontakt ist.

24. Verfahren zum Herstellen eines Solarpanel-Moduls (M), das umfasst:
Bereitstellen wenigstens eines Halbleitersubstrats, wobei das wenigstens eine Halbleitersubstrat einen Volumenleitfähigkeitstyp hat, Texturieren der Vorderseite und Versehen der Vorderseite mit einer dotierten Schicht (4) eines ersten Leitfähigkeitstyps, um die Vorderseite so einzurichten, dass sie in Funktion Strahlungsenergie einfängt, Bereitstellen eines transparenten Trägers (1), Anbringen des wenigstens einen Halbleitersubstrats an dem transparenten Träger, wobei die Vorderseite des wenigstens einen Halbleitersubstrats dem transparenten Träger zugewandt ist, Teilen des wenigstens einen Halbleitersubstrats in Halbleitersubstrat-Abschnitte (3a, 3b, 3c), wobei jeder Halbleitersubstrat-Abschnitt eine Vorderseite (F) und eine Rückseite (R) hat, die Halbleitersubstrat-Abschnitte nebeneinander auf dem transparenten Träger angeordnet sind und durch eine Nut (G) voneinander getrennt sind, wobei jede Nut eine Seitenwand (W) jedes der nebeneinander befindlichen Halbleitersubstrat-Abschnitte umfasst, Abscheiden einer Schicht aus Eigenhalbleitermaterial (5) auf der Rückseite und auf Seitenwänden der Nuten, Erzeugen eines ersten elektrischen Kontaktes für Minoritätsladungsträger in dem Halbleitersubstrat-Abschnitt in jedem Halbleitersubstratabschnitt und Erzeugen eines zweiten elektrischen Kontaktes für Majoritätsladungsträger in dem Halbleitersubstrat-Abschnitt, wobei der erste elektrische Kontakt wenigstens an der Rückseite jedes Halbleitersubstrat-Abschnitts erzeugt wird, und der erste elektrische Kontakt eine Heterostruktur eines ersten Typs umfasst, der Heteroübergang des ersten Typs eine Eigenhalbleiterschicht (5) auf dem Halbleitersubstrat-Abschnitt und eine Halbleiterschicht (7) eines zweiten Leitfähigkeitstyps über der Eigenhalbleiterschicht umfasst, der zweite Leitfähigkeitstyp dem ersten Leitfähigkeitstyp entgegengesetzt ist, da die Eigenhalbleiterschicht auf dem Halbleitersubstrat-Abschnitt und die Halbleitermaterialschicht eines zweiten Leitfähigkeitstyps über der Eigenhalbleiterschicht wenigstens an der Rückseite jedes Halbleitersubstrat-Abschnitts abgeschieden werden, wobei der zweite Leitfähigkeitstyp dem ersten Leitfähigkeitstyp entgegengesetzt ist.

25. Verfahren nach Anspruch 24, das des Weiteren umfasst:
Abscheiden einer leitenden Schicht an der Rückseite und den Nuten, Ausführen eines Isolierungsprozesses zum Unterbrechen der leitenden Schicht zwischen einer Position des ersten elektrischen Kontaktes und einer Position des zweiten elektrischen Kontaktes auf jedem Halbleitersubstrat-Abschnitt.

## Revendications

1. Module de panneau solaire (M) comprenant :
un support transparent (1), des parties de substrat semi-conducteur au silicium (3a, 3b, 3c) ayant une surface avant (F) et une surface arrière (R), la surface avant étant agencée, en cours d'utilisation, pour capturer une énergie de rayonnement ;
les parties de substrat semi-conducteur étant agencées de manière adjacente les unes aux autres sur le support transparent et étant séparées les unes des autres par une rainure (G), chaque partie de substrat semi-conducteur étant fixée par la surface avant au support transparent, chaque rainure comprenant une paroi latérale (W) de chacune des parties de substrat semi-conducteur adjacentes les unes aux autres ;
les parties de substrat semi-conducteur étant d'un type de conductivité volumique ;
la surface avant de chaque partie de substrat semi-conducteur étant pourvue d'une couche dopée (4) d'un premier type de conductivité ;
chaque partie de substrat semi-conducteur comprenant un premier contact électrique (5, 7) pour des porteurs de charge minoritaires dans la partie de substrat semi-conducteur et un deuxième contact électrique (6) pour des porteurs de charge majoritaires dans la partie de substrat semi-conducteur ;
le premier contact électrique étant agencé sur au moins la surface arrière de la partie de substrat semi-conducteur, où le premier contact électrique est une hétérostructure d'un premier type, l'hétérojonction du premier type comprenant une couche de semi-conducteur intrinsèque (7) sur la partie de substrat semi-conducteur et une couche de semi-conducteur d'un deuxième type de conductivité sur la partie supérieure de la couche de semi-conducteur intrinsèque, le deuxième type de conductivité étant opposé au premier type de conductivité.

2. Panneau solaire selon la revendication 1, dans lequel la couche de matériau semi-conducteur intrinsèque comprend du silicium amorphe.

3. Panneau solaire selon la revendication 1 ou 2, dans lequel la couche de matériau semi-conducteur du deuxième type de conductivité comprend du silicium amorphe contenant une ou plusieurs espèce(s) de dopant, entraînant le deuxième type de conductivité.

4. Cellule solaire selon l'une quelconque des revendications précédentes, dans laquelle la couche de semi-conducteur intrinsèque recouvre la rainure entre des parties adjacentes de substrat semi-conducteur.

5. Cellule solaire selon la revendication 4, dans laquelle la couche de matériau semi-conducteur du deuxième type de conductivité recouvre au moins essentiellement la surface arrière.

6. Cellule solaire selon la revendication 5, dans laquelle la couche de matériau semi-conducteur du deuxième type de conductivité recouvre la paroi latérale de la partie de substrat semi-conducteur qui ne comprend pas le deuxième contact électrique.

7. Module de panneau solaire selon l'une quelconque des revendications précédentes 1 à 6, dans lequel le deuxième contact électrique est une zone de contact fortement dopée du premier type de conductivité, dans une paroi latérale de la partie de substrat semi-conducteur.

8. Module de panneau solaire selon l'une quelconque des revendications précédentes 1 à 6, dans lequel le deuxième contact électrique est une zone de contact fortement dopée du premier type de conductivité, dans une partie de la surface arrière de la partie de substrat semi-conducteur adjacente au premier contact électrique.

9. Module de panneau solaire selon l'une quelconque des revendications précédentes 1 à 6, dans lequel le deuxième contact électrique est une hétérojonction d'un deuxième type, l'hétérojonction du deuxième type comprenant une couche de semi-conducteur intrinsèque et une couche de semi-conducteur du premier type de conductivité, essentiellement sur une paroi latérale de la partie de substrat semi-conducteur.

10. Module de panneau solaire selon l'une quelconque des revendications précédentes, dans lequel une couche conductrice est agencée sur la surface arrière et les parois latérales de chaque partie de substrat semi-conducteur, et dans lequel sur chaque partie de substrat semi-conducteur la couche conductrice comprend un élément d'interruption entre l'emplacement du premier contact électrique et l'emplacement du deuxième contact électrique.

11. Module de panneau solaire selon la revendication 10, dans lequel l'élément d'interruption est soit une fente dans la couche conductrice, soit un élément de marche isolateur dans la couche conductrice.

12. Module de panneau solaire selon la revendication 10 ou 11, tant qu'elle dépend de la revendication 7 ou 8, dans lequel une couche de passivation est agencée sur la zone de contact fortement dopée, la couche de passivation ayant une ouverture pour l'exposition d'au moins une partie de la zone de contact fortement dopée en vue d'une connexion avec la couche conductrice.

13. Module de panneau solaire selon la revendication 8, dans lequel la rainure entre des parties adjacentes de substrat semi-conducteur est remplie d'un matériau isolant.

14. Module de panneau solaire selon la revendication 8 ou 13, dans lequel la rainure entre des parties adjacentes de substrat semi-conducteur est pontée par un élément de pontage.

15. Panneau solaire selon l'une quelconque des revendications précédentes, dans lequel la rainure est effilée dans une direction allant du support transparent vers le côté de surface arrière des parties de substrat semi-conducteur.

16. Panneau solaire selon l'une quelconque des revendications précédentes, dans lequel la rainure est soit perpendiculaire à la surface arrière soit effilée dans une direction allant du côté de surface arrière des parties de substrat semi-conducteur vers le support transparent.

17. Module de panneau solaire selon l'une quelconque des revendications précédentes, dans lequel le type de conductivité volumique est le premier type de conductivité.

18. Module de panneau solaire selon la revendication 4, dans lequel le type de conductivité volumique est le deuxième type de conductivité et le deuxième contact électrique est connecté à la couche dopée d'un premier type de conductivité dans la surface avant de chaque partie de substrat semi-conducteur.

19. Panneau solaire selon la revendication 15 ou 16, dans lequel des parois latérales de chacune des parties de substrat semi-conducteur sont exposées.

20. Panneau solaire selon la revendication 15 ou 16, dans lequel des parois latérales de chacune des parties de substrat semi-conducteur sont recouvertes d'une couche de surface dopée du premier type de conductivité.

21. Panneau solaire selon la revendication 20, dans lequel la couche de surface dopée sur les parois latérales de chacune des parties de substrat semi-conducteur est recouverte d'une couche de passivation.

22. Panneau solaire selon la revendication 15 ou 16, dans lequel des parois latérales de chacune des parties de substrat semi-conducteur sont recouvertes d'une couche de passivation.

23. Panneau solaire selon la revendication 7 ou 8, dans lequel une partie du deuxième contact électrique est recouverte soit de la couche de semi-conducteur intrinsèque soit d'une couche de passivation, et une couche conductrice vient en contact avec une partie restante du deuxième contact électrique à travers une ouverture dans la couche de semi-conducteur intrinsèque ou dans la couche de passivation, respectivement.

24. Procédé de fabrication d'un module de panneau solaire (M) comprenant le fait :
de fournir au moins un substrat semi-conducteur, l'au moins un substrat semi-conducteur ayant un type de conductivité volumique ; de texturer la surface avant et de fournir à la surface avant une couche dopée (4) d'un premier type de conductivité pour agencer la surface avant afin de capturer, en cours d'utilisation, une énergie de rayonnement ; de fournir un support transparent (1) fixant l'au moins un substrat semi-conducteur au support transparent, la surface avant de l'au moins un substrat semi-conducteur faisant face au support transparent ; de diviser l'au moins un substrat semi-conducteur en des parties de substrat semi-conducteur (3a, 3b, 3c), chaque partie de substrat semi-conducteur ayant une surface avant (F) et une surface arrière (R) ; les parties de substrat semi-conducteur étant agencées de manière adjacente les unes aux autres sur le support transparent et étant séparées les unes des autres par une rainure (G), chaque rainure comprenant une paroi latérale (W) de chacune des parties adjacentes de substrat semi-conducteur ; de déposer une couche de matériau semi-conducteur intrinsèque (5) sur la surface arrière et sur des parois latérales des rainures ;
de créer dans chaque partie de substrat semi-conducteur un premier contact électrique pour des porteurs de charge minoritaires dans la partie de substrat semi-conducteur et de créer un deuxième contact électrique pour des porteurs de charge majoritaires dans la partie de substrat semi-conducteur, où le premier contact électrique est créé sur au moins la surface arrière de chaque partie de substrat semi-conducteur et le premier contact électrique comprend une hétérostructure d'un premier type, l'hétérojonction du premier type comprenant une couche de semi-conducteur intrinsèque (5) sur la partie de substrat semi-conducteur et une couche de semi-conducteur (7) d'un deuxième type de conductivité sur la partie supérieure de la couche de semi-conducteur intrinsèque, le deuxième type de conductivité étant opposé au premier type de conductivité par dépôt de la couche de semi-conducteur intrinsèque sur la partie de substrat semi-conducteur et de la couche de matériau semi-conducteur d'un deuxième type de conductivité sur la partie supérieure de la couche de semi-conducteur intrinsèque sur au moins la surface arrière de chaque partie de substrat semi-conducteur, le deuxième type de conductivité étant opposé au premier type de conductivité.

25. Procédé selon la revendication 24, comprenant en outre le fait : de déposer une couche conductrice sur la surface arrière et les rainures ; de mettre en oeuvre un processus d'isolation pour interrompre la couche conductrice entre un emplacement du premier contact électrique et un emplacement du deuxième contact électrique sur chaque partie de substrat semi-conducteur.
